# EUROPEAN PATENT SPECIFICATION

(11) **EP 3 926 769 B1**
(45) Date of publication and mention of the grant of the patent: **18.01.2023**
(21) Application number: 20180755.9
(22) Date of filing: 18.06.2020
(51) Int. Cl.: H01S 5/026, H01S 5/183

(54) **METHOD OF PRODUCING A VERTICAL CAVITY SURFACE EMITTING LASER**
VERFAHREN ZUR HERSTELLUNG VON EINEM OBERFLÄCHENEMITTIERENDEN LASER MIT VERTIKALEM RESONATOR
PROCÉDÉ DE PRODUCTION D'UN LASER À CAVITÉ VERTICALE ET À ÉMISSION PAR LA SURFACE

(43) Date of publication of application: 22.12.2021
(73) Proprietor: TRUMPF Photonic Components GmbH, 89081 Ulm (DE)
(72) Inventor: Weichmann, Ulrich, 89081 Ulm (DE); Bader, Sven, 89081 Ulm (DE)
(74) Representative: Trumpf Patentabteilung

(56) References cited:
- WO-A1-2009/136348
- US-A1- 2006 227 835
- US-A1- 2015 303 655
- US-A1- 2020 119 521

## Description

### FIELD OF THE INVENTION

The invention relates to a method of producing a Vertical Cavity Surface Emitting Laser (VCSEL).

### BACKGROUND OF THE INVENTION

VCSELs are a type of semiconductor laser diodes with laser beam emission perpendicular to the top or bottom surface. Typically, a VCSEL comprises a layer stack of semiconductor layers. Some or all of the semiconductor layers of the layer stack form an optical resonator comprising a first mirror, a second mirror and an active region between the first and second mirrors. The mirrors may be configured as distributed Bragg reflector (DBR) mirrors. DBR-mirrors typically comprise layers with alternating high and low refractive indices. In common VCSELs, the first and second mirrors comprise p-type and n-type doped materials, forming a diode junction. In other conventional configurations, the p-type and n-type regions may be embedded between the mirrors. The active region may comprise one or more quantum wells for laser light generation. The layer stack of semiconductor layers is typically grown on a wafer or substrate by epitaxial methods.

Common VCSELs usually include an epitaxially grown high aluminum content AIGaAs layer, respectively AlAs layer in close vicinity of the active region. During a wet-thermal oxidation process, this layer turns partly from the edge to the center of the layer into an isolating AlₓO_{y} material. The oxidation process serves to integrate an oxide aperture into the VCSEL, in order to raise the current density very close to the active pn-junction and to provide optical guiding for the laser mode. Current confinement may be essential to reach high current densities which will decrease the threshold current for lasing and ensure highly efficient devices. Further functions of the AlAs-layer - besides current and optical confinement - have not been expected in the past.

Some conventional VCSELs comprise an intracavity contact, as disclosed in US 6 026 108 A1. When making an intracavity contact with good yield, extreme tolerances in the etching process or a thick epitaxial layer are required, which however leads to high absorption losses of the VCSEL.

US 2006/0227835 A1 discloses a surface emitting semiconductor laser diode of a tunnel junction type including a semiconductor substrate, a first reflector, a second reflector, an active region disposed in series between the first and second reflectors, and a tunnel junction region disposed in series between the first and second reflectors. The tunnel junction region includes a first semiconductor layer of a first conductive type and a semiconductor layer of a second conductive type that forms a junction with the first semiconductor layer, the first semiconductor layer being composed of a super-lattice layer that at least partially includes aluminum and is partially oxidized.

US 2015/0303655 A1 discloses methods and structures for forming vertical-cavity light-emitting devices. An n-side or bottom-side layer may be laterally etched to form a porous semiconductor region and converted to a porous oxide. The porous oxide can provide a current-blocking and guiding layer that aids in directing bias current through an active area of the light-emitting device. Distributed Bragg reflectors may be fabricated on both sides of the active region to form a vertical-cavity surface-emitting laser. The light-emitting devices may be formed from III-nitride materials.

### SUMMARY OF THE INVENTION

It is an object of the invention to provide a method of producing a VCSEL which may be provided with an intracavity contact, and which can be performed with high yield without requiring excessive tolerances in the etching process or a thick epitaxial layer.

According to an aspect, a method of producing a Vertical Cavity Surface Emitting Laser is provided, comprising:
providing a layer stack of semiconductor layers, the semiconductor layers of the layer stack including a first mirror, a second mirror, an active region between the first and second mirrors, an Al₁₋ₓGaₓAs - layer with 0≤ x ≤ 0.05, and a contact layer immediately adjacent to the Al₁₋ₓGaₓAs - layer;
etching the layer stack to obtain a first layer sub-stack forming a mesa and a second layer sub-stack adjacent to the mesa in stacking direction of the layer stack, the layers of the second layer sub-stack extend beyond the layers of the first layer sub-stack in direction perpendicular to the stacking direction, and using the Al₁₋ₓGaₓAs -layer as an etch-stop layer;
removing an outer part of the Al₁₋ₓGaₓAs -layer to expose in part the contact layer;
oxidizing the Al₁₋ₓGaₓAs -layer to obtain an oxide aperture layer.

In the following description, the Al₁₋ₓGaₓAs layer is briefly referred to as AlAs layer. The term 'AlAs layer' as used herein also includes an Al₁₋ₓGaₓAs-layer with 0 < x ≤ 0.05.

The method according to the invention allows for making an intracavity contact with high yield without requiring excessive tolerances in the etching process or a thick epitaxial layer. This advantage is achieved according to the invention by an AlAslayer arranged as the last layer or the lowermost layer of the mesa, when seen from top of the mesa to the bottom of the mesa. Such a position of an AlAs-layer provides a dual-functionality of the AlAs-layer. A first function of the AlAs-layer is that it can be oxidized to provide the oxide aperture for current and optical confinement, as it is the case with conventional VCSELs. A second advantageous function of this AlAs- layer which has not been expected heretofore is that it can also be used as an etch-stop layer in the etching process of forming the mesa. The AlAs-etch-stop layer ensures a precise control of the etch depth, which is essential to target the contact layer immediately adjacent, or, when seen from top to bottom of the mesa, immediately below the AlAs-layer. An advantage here is that the contact layer immediately adjacent to the AlAs-layer can be made very thin without the risk that such a thin layer is removed in part or completely by the etching process. The contact layer may be used for providing an ohmic contact thereon. Thus, an intracavity contact can be easily formed in the VCSEL with high yield and without a thick epitaxial layer. As a further advantage, the absorption losses of the VCSEL are reduced in comparison with conventional VCSELs having an intracavity contact.

When the outer part of the AlAs-layer is removed to expose in part the contact layer, two important steps of the method are reached simultaneously: the remaining AlAs-layer in the mesa can now be oxidized to create the current aperture in the center of the mesa, and in addition the layer directly below the dual-functional AlAs-layer is now open outside the mesa tower. The advantage of the method according to the invention is the exact targeting of the opening of the layer directly below the AlAs-layer. This is particularly advantageous, because the specific positioning of the contact layer is crucial for operation. For example, the specific position of the contact layer may be in a node of the standing wave field of the laser light in the resonator during operation of the VCSEL.

A metal or ohmic contact may be arranged on the exposed outer part of the contact layer in a further step.

Preferentially, the etching includes a selective etching process which automatically stops at the AlAs-layer.

The selective etching process may be a selective wet-chemical etching process. For example, selective wet-chemical-etching may be performed with NH₃:H₂O₂.

Further preferentially, the selective etching process may be preceded by an initial etching process, and further comprising stopping the initial etching process one or more layers apart from the AlAs-layer.

This measure has the advantage that the initial etching process may be performed using an etching process different from the selective etching process, and which is more suitable to obtain straight edges of the mesa during mesa formation. Since the initial etching process might not automatically stop at the AlAs-etch-stop layer, it is advantageous to stop the initial etching process one or more layers apart from the AlAs-layer. The outer parts of the one or more remaining layers still present above the AlAs-layer, e.g. AIGaAs/GaAs-based layers, are removed by the selective etching process which automatically stops at the AlAs-layer.

The initial etching process may be a dry etching process. Preferably, reactive ion etching (RIE) or inductively coupled plasma (ICP) etching processes are preferred as the dry etching process.

The layer stack of semiconductor layers may be provided by epitaxially growing semiconductor layers on a wafer or substrate. The substrate may be removed after the VCSEL is produced.

Preferentially, the contact layer may be arranged in a node of a standing wave field of generated laser light in the optical resonator.

A position of the contact layer in a node of a standing wave field of laser light in the optical resonator has the advantage that absorption losses by the contact layer are further reduced, in particular if the contact layer is highly doped.

Preferentially, the contact layer may have a doping concentration sufficient for ohmic behaviour of the contact layer.

The doping concentration of the contact layer may be at least 6 x 10¹⁸ cm⁻³. The contact layer may be a doped GaAs-Layer.

Preferentially, the doping concentration in the contact layer may gradually decrease in thickness direction of the contact layer from a side facing the oxide aperture layer to the opposite side, or the doping concentration may gradually decrease from the contact layer to an adjacent layer on a side of the contact layer facing away from the oxide aperture layer.

These measures advantageously increase the lateral mobility of the carriers and lead to an improved conductivity of the contact layer.

Further preferentially, the contact layer may have a thickness of at least 10 nm. The thickness of the contact layer may be at least 15 nm, for example about 20 nm.

Providing the contact layer with a very small thickness advantageously reduces absorption of generated laser light by the contact layer. The smaller the thickness, the lower the absorption losses.

The present invention can be used in all standard VCSEL structures. However, the present invention is most useful in three-port lasers, as for example in VCSELs with integrated photodiode (ViPs). The present invention can find implementation in three-port devices, like an npn- or pnp-ViP.

Further preferentially, the contact layer may be a p-doped contact layer. The dopant may be carbon (C), zinc (Zn), or any other suitable dopant or a combination thereof in case of a p-contact layer, with a high dopant level of e.g. at least 6 x 10¹⁸ cm⁻³. The present invention is particularly suitable for configuration of the VCSEL as an npn-three-port device.

The VCSEL may comprise a photodiode having an intrinsic absorption region integrated into one of the first and second mirrors. Thus, the VCSEL may be a ViP with the advantageous integration of the absorption region of the photodiode into one of the first and second mirrors.

The first and second mirrors of the VCSEL may be configured as distributed Bragg reflectors (DBRs). The first and second mirrors may be built up by a plurality of pairs of layers with alternating high and low refractive indices. The second mirror may have a first portion facing the contact layer, which is a p-doped region of the layer stack, and a second portion facing away from the contact layer, which is an n-doped region of the layer stack, wherein the intrinsic absorption region of the photodiode is arranged between the first and second portions of the second mirror. The first mirror may be an n-doped region of the layer stack.

In these configurations, the VCSEL produced according to the invention may be advantageously configured as an npn-ViP. In comparison with conventional ViPs having a pnpn-configuration, the npn-configuration has the advantage that one of the three pn-junctions is dispensed with. Thus, an unnecessary parasitic diode integrated into the device can be omitted. The voltage drop to forward bias the parasitic diode is no longer required and, thus, the photodiode bias voltage is reduced when one of three pn-junctions of the conventional ViP is removed. Further, the epitaxial growth of the npn-ViP becomes simplified and the risk to build up an eventually integrated phototransistor structure with breakthrough scenarios is reduced.

In a further configuration, at least one mirror layer pair of the second mirror may be arranged between the active region and the oxide aperture layer.

In this configuration, the dual-functional AlAs-layer is positioned more distant from the active region, whereby the efficiency of the current confinement would drop, however the optical guiding, too. This leads to a smaller numerical aperture (NA), which is beneficial in ViPs. For example, one to five mirror pairs, e.g. p-mirror pairs, may be arranged between the AlAs-layer and the active region.

The VCSEL may be a top emitter or a bottom emitter.

Further advantageous embodiments are defined below.

### BRIEF DESCRIPTION OF THE DRAWINGS

These and other aspects of the invention will be apparent from and elucidated with reference to the embodiments described hereinafter. In the following drawings:
- Fig. 1: schematically shows a sketch of an embodiment of a VCSEL;
- Fig. 2: shows a flow chart of a method of producing a VCSEL;
- Fig. 3: shows a pre-stage of the VCSEL in Fig. 1 in a stage of the method of producing the VCSEL;
- Fig. 4: shows the pre-stage of the VCSEL in a further stage of the method of producing the VCSEL;
- Fig. 5: shows the pre-stage of the VCSEL in a further stage of the method of producing the VCSEL; and
- Fig. 6: shows the pre-stage of the VCSEL in a further stage of the method of producing the VCSEL.

### DETAILLED DESCRIPTION OF THE INVENTION

According to the principles of the invention, a Vertical Cavity Surface Emitting Laser (VCSEL) comprises a dual-functional Al₁₋ₓGaₓAs layer with 0 ≤ x ≤ 0.05 which includes the case of an AlAs (aluminum arsenide) layer. In the following description and in the drawings, only the term AlAs-layer is used, which however does not exclude the case of an Al₁₋ₓGaₓAs layer with 0 < x ≤ 0.05.

The dual functionality of the AlAs-layer arises from using the AlAs-layer to provide an oxide aperture layer forming a current aperture on the one hand. On the other hand, the AlAs-layer is used as an etch-stop layer in the process of producing the VCSEL to ensure a precise control of the etching process. A precise control of the etching process in the process of producing the VCSEL is essential to target a thin layer immediately adjacent to the AlAs-layer, in particular if this adjacent layer is a contact layer for forming an intracavity contact.

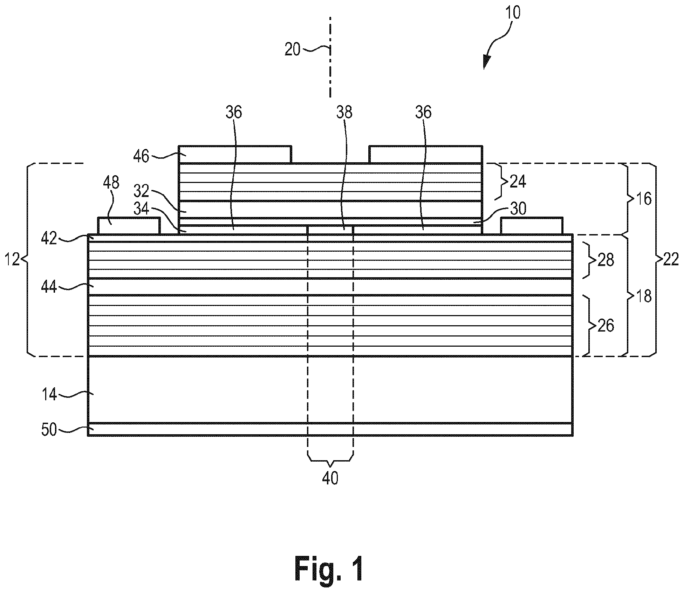

An embodiment of a VCSEL 10 which makes use of the principles of the present disclosure is shown in Fig. 1. It is to be understood that the principles of the present disclosure are not limited to the embodiment shown in Fig. 1, but can be used in all other VCSEL structures, in particular in all standard VCSEL structures.

The VCSEL 10 in Fig. 1 comprises a layer stack 12 of semiconductor layers. The layer stack 12 may be arranged on a substrate 14. The layer stack 12 comprises a first layer sub-stack 16 forming a mesa of the VCSEL 10. The layer stack 12 comprises a second layer sub-stack 18 which is immediately adjacent to the sub-stack 16 forming the mesa in stacking direction of the layer stack 12. In Fig. 1, the stacking direction of the layer stack 12 is illustrated by an axis 20. The semiconductor layers of the second sub-stack 18 extend beyond the semiconductor layers of the first sub-stack 16 (mesa) in direction perpendicular to the stacking direction 20, as shown in Fig. 1.

The semiconductor layers of the layer stack 12 form an optical resonator 22. The optical resonator 22 comprises a first mirror 24. The first mirror 24 may be configured as a distributed Bragg reflector (DBR). The first mirror 24 may comprise a plurality of semiconductor layer pairs based on the AIGaAs/GaAs material system, wherein the layer pairs have alternating high refractive index and low refractive index layers.

The optical resonator 20 further comprises a second mirror which is, in the embodiment shown, divided into three portions, a first portion 26, a second portion 28, and a third portion 30. The second mirror comprising the portions 26, 28, 30 may comprise a plurality of layer pairs with alternating high refractive and low refractive indices based on the AIGaAs/GaAs material system.

The optical resonator 22 further comprises an active region 32 which is arranged between the first mirror 24 and the second mirror comprising the portions 26, 28, 30. The active region 32 may comprise one or more quantum well layers, for example based on GaAs. The active region 32 is arranged to generate laser light with a wavelength of e.g. 850 nm (in air) or greater.

Further included in the layer stack 12 is an oxide aperture layer 34. The oxide aperture layer 34 comprises an oxidized outer region 36 which is electrically non-conducting, and a non-oxidized center region 38 which is electrically conducting. The oxide aperture layer 34 is based on AlAs, wherein the outer region 36 comprises an oxide of AlAs, e.g. AlₓO_{y}. The center region 38 comprises non-oxidized AlAs. The center region 38 forms an aperture 40 for current and optical confinement.

The optical resonator 22 further comprises a contact layer 42 which is immediately adjacent to the oxide aperture layer 34. While the oxide aperture layer 34 forms the last layer of the first sub-stack 16 forming the mesa, the contact layer 42 is the first layer of the second sub-stack of semiconductor layers. In order to function as a contact layer, the contact layer 42 has a doping concentration sufficient for ohmic behaviour of the contact layer. The doping level of the contact layer 42 may be as high as 6 x 10¹⁸ cm⁻³ or higher. In case the contact layer 42 is a p-contact layer, the dopant may be carbon (C) or Zinc (Zn) or any other p-type dopant or even a combination of several of them. The contact layer 42 preferentially is a thin layer. As such, the thickness of the contact layer may be at least 10 nm, or at least 15 nm, for example about 20 nm.

The doping concentration in the contact layer 42 may gradually decrease in the thickness direction of the contact layer 42 from a side facing the oxide aperture layer 34 to the side facing the second portion of the second mirror 28. Alternatively, the doping concentration may be constant in the contact layer 42 if the contact layer 42 is thin, e.g. 10 nm, and the doping concentration may gradually decrease to a layer following this thin contact layer 42 on a side facing away from the oxide aperture layer 34.

In a preferred embodiment, the VCSEL 10 further may comprise an integrated photodiode comprising an intrinsic absorption region 44 which may comprise one or more intrinsic absorption and additional intrinsic layers. The photodiode absorption region 44 is embedded in the second mirror, here between the first and second portions 26, 28 of the second mirror. The first portion 26 has a different doping polarity than the second portion 28 so that the first and second portions 26, 28 form an np- or a pn-junction of the photodiode.

The VCSEL 10 further comprises a contact arrangement for driving the VCSEL 10. The electrical contact arrangement comprises a first electrical contact 46, here formed as a ring electrode which is arranged on the outer side of the first sub-stack 16 forming the mesa. The electrical contact arrangement further comprises a second electrical contact 48 configured as an intracavity contact. The electrical contact 48 is in contact with the contact layer 42. The electrical contact 48 is configured in the present embodiment as a ring electrode.

A third electrical contact 50 may be arranged on an outer side of the substrate 14. The first and second electrical contacts 46, 48 serve to drive the VCSEL 10 for laser emission. The electrical contacts 48 and 50 serve to drive the photodiode.

During operation of the VCSEL 10, the generated laser light forms a standing wave field within the resonator 22. The contact layer 42 is preferably arranged in a node of this standing wave field of laser light in the optical resonator 22 in order to reduce absorption losses to which the high doping level of the contact layer 42 might give rise. In this regard, a thin contact layer 42 arranged in a node of the standing wave field of the laser light in the optical resonator 22 is preferred.

Further, in the present embodiment, the oxide aperture layer 34 based on AlAs is spaced apart from the active region 32 by the third portion 30 of the second mirror. The third portion 30 may comprise one or more mirror pairs, e.g. one to five mirror pairs. A separation of the oxide aperture layer 34 from the active region 32 by one or more layers may drop the efficiency of the current confinement provided by the oxide aperture layer 34, but also the optical guiding. The latter leads to a smaller numerical aperture (NA), which is beneficial in VCSELs with integrated photodiodes (ViPs).

In the present embodiment, the VCSEL 10 is a ViP. The ViP may be an npn-ViP, or a pnp-ViP. Preferentially, the VCSEL 10 is an npn-ViP. In this case, the electrical contact 46 is an n-contact, and the first mirror 24 is an n-mirror. The second and third portions 28, 30 of the second mirror are p-doped, and the first portion 26 of the second mirror is n-doped. The intracavity contact 48 is a p-contact, and the contact layer 42 is a p-contact layer, accordingly. The bottom contact 50 is an n-contact. For a pnp-ViP, the polarities described above are reversed, accordingly.

Thus, the ViP only has two pn-junctions, thus dispensing with one parasitic pn-junction as in conventional ViPs.

The contact layer 42 may be a GaAs-layer.

The VCSEL may be a top emitter, wherein the reflectivity of the first mirror 24 is slightly reduced in comparison with the reflectivity of the second mirror so that the first mirror 24 serves as an out-coupling mirror. In other embodiments (not shown), the VCSEL 10 may be configured as a bottom emitter, wherein the reflectivity of the second mirror then is slightly reduced in comparison with the first mirror 24. For a bottom emitter, the bottom contact 50 may be configured as a ring electrode to allow laser light to exit through the aperture of the bottom electrode. In further embodiments (not shown), the substrate 14 may be removed.

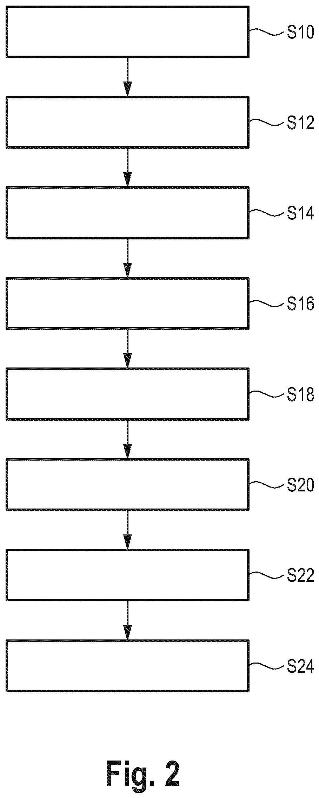

In the following, an embodiment of a method of producing a VCSEL will be described with reference to Figs. 2 to 6. For the sake of simplicity, the method of producing a VCSEL will be described based on the VCSEL 10 in Fig. 1.

According to the principles of the present disclosure, an AlAs-layer incorporated into the epitaxial stack is used with dual functionality, namely on the one hand to provide an oxide aperture layer, and on the other hand, to provide an etch-stop layer in the process of producing the VCSEL.

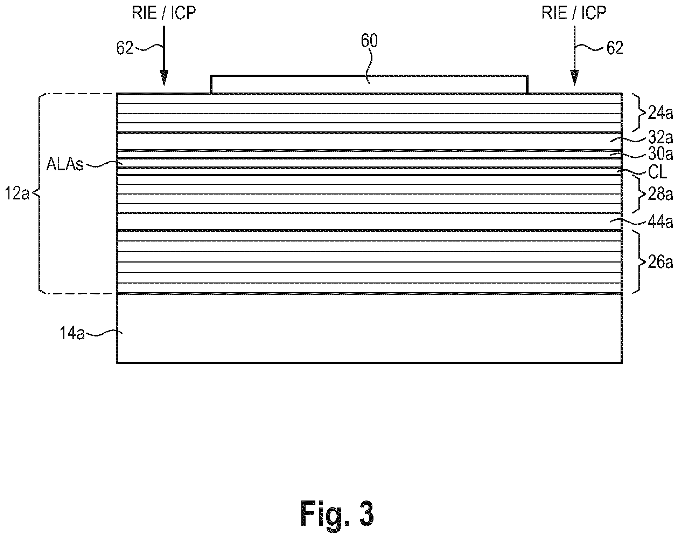

According to Fig. 2, the method may begin at S10. At S10, a layer stack 12a is provided as shown in Fig. 3. The layer stack 12a may be provided on a substrate or wafer 14a. The semiconductor layers of layer stack 12a include layers 24a of a first mirror, one ore more layers 32a of an active region, one or more layers 30a of a third portion of a second mirror, an aluminum-arsenide layer 'AlAs', a contact layer CL, layers 28a of a second portion of a second mirror, one or more layers 44a of an absorption region of a photodiode, layers 26a of a first portion of the second mirror.

The afore-mentioned layers may have been epitaxially grown on the substrate 14a.

At S12 in Fig. 2, and further with reference to Fig. 3, the subsequent etching process to obtain a mesa is prepared by covering the upper surface of the layer stack 12a with photoresist 60 in a region of the layer stack 12a where the mesa is to be formed.

Next, the layer stack 12a is etched to gradually form the mesa. Preferentially, the etching process is divided into two successive etching processes, an initial etching process and a subsequent etching process.

At S14 in Fig. 2 and with continued reference to Fig. 3, the initial etching process is performed using a dry etching process. For example, dry etching may be performed with reactive ion etching (RIE) or inductively coupled plasma (ICP) etching. These etching processes are advantageous as they are suitable to obtain straight edges of the mesa to be formed. In Fig. 3, the initial etching process is illustrated by arrows 62.

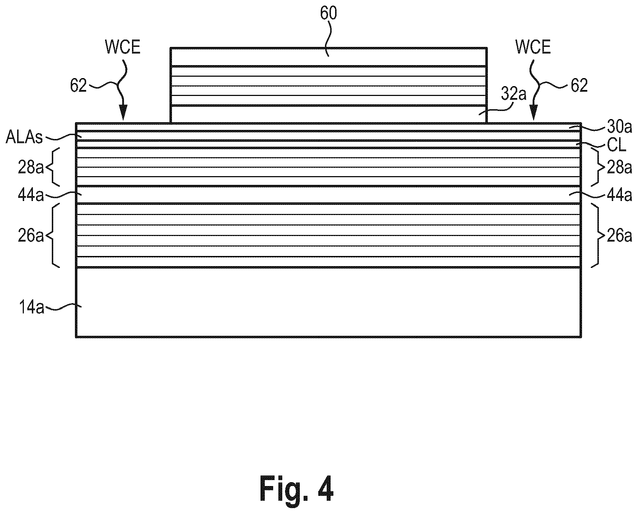

At S16 in Fig. 2 and as shown in Fig. 4, the initial etching process is stopped one or more layers before the initial etching process reaches the AlAs-layer. When the initial etching process is stopped, a part of a first sub-stack of semiconductor layers and thus a part of a mesa is formed. For example, the initial etching process may be stopped when the etching reaches a layer of the third portion 30a of the second mirror, above the AlAs-layer.

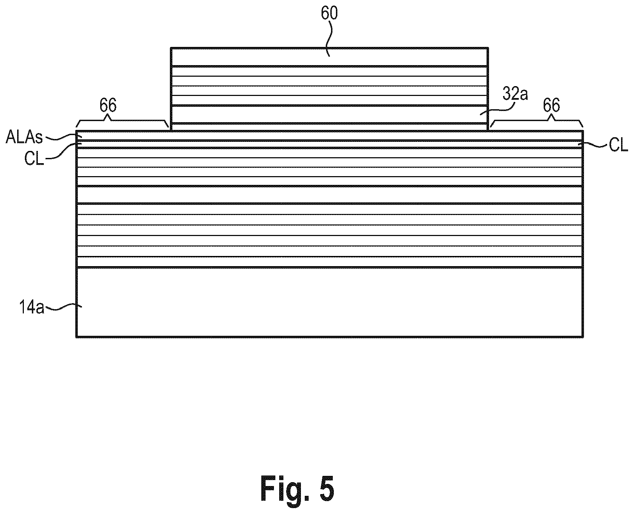

At S18 in Fig. 2 and as shown in Fig. 4, etching the layer stack 12a is continued by a selective etching process, in particular a selective wet-chemical etching process (WCE) as illustrated in Fig. 4 by arrows 64. The selective wet-chemical etching process is chosen to stop automatically when reaching the AlAs-layer. The selective etching process removes the remaining semiconductor layers, e.g. AIGaAs/GaAs-based layers of the third portion 30a of the second mirror above the AlAs-layer. A suitable etching agent for selective wet-chemical etching is, for example NH₃:H₂O₂ (pH 8.3). Fig. 5 shows the stage of the method when the selective etching process has automatically stopped at the AlAs-layer. Instead of a wet-chemical etching process, a selective dry chemical etching process, in particular without physical component, may be used.

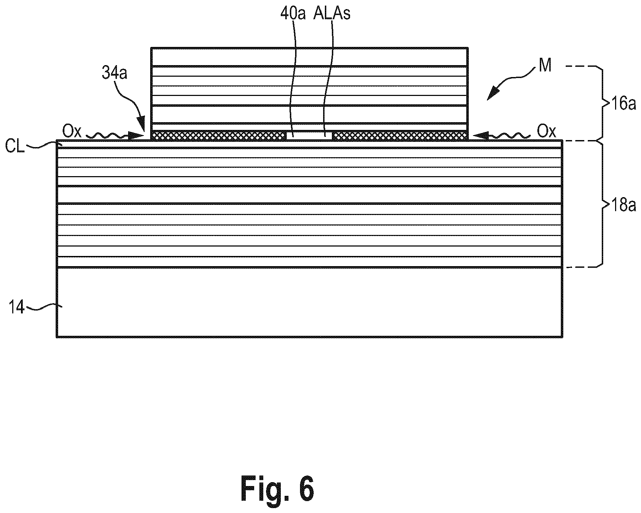

Subsequently, at S20 in Fig. 2 and as shown in Fig. 6, an outer part 66 of the AlAs-layer is removed, which can be performed by etching with, e.g. HF:H₂O or HCl:H₂O. The mesa is now readily obtained, with the remaining inner part of the AlAs layer forming the lowermost layer of the mesa.

By removing the outer part 64 of the AlAs-layer, two important steps are reached simultaneously: The remaining AlAs-layer which is included in the mesa, can now be oxidized at S22 to create the current aperture 40a in the center of the mesa, plus the contact layer directly adjacent to the dual-functional AlAs-layer is now open outside the mesa tower. The advantage of the method according to the principles of the present disclosure thus is the exact targeting of the opening of the layer, here the contact layer CL, directly below the oxide aperture. This is particular advantageous for the contact layer CL, as the specific positioning of the contact layer CL is crucial for reliable operation of the VCSEL.

In Fig. 6, the oxidizing process is illustrated by "Ox" and the crosses in the AlAs-layer illustrate the oxidized outer region of the current aperture layer 34a obtained in this way. As shown in Fig. 6, the photoresist 60 is removed.

At S24 in Fig. 2, electrical contacts like electrical contacts 46, 48 and 50 shown in Fig. 1 may be provided on the layer stack 12a.

When the VCSEL according to the present disclosure is configured as ViP, it may be used in sensors, such as sensor for gesture control, velocity and distance measurement, particle density measurement, 3D-cameras, etc., in particular in sensing applications based on self-mixing interference.

While the invention has been illustrated and described in detail in the drawings and foregoing description, such illustration and description are to be considered illustrative or exemplarily and not limiting; the invention is not limited to the disclosed embodiments. Other variations to the disclosed embodiments can be understood and effected by those skilled in the art and practicing the claimed invention, from a study of the drawings, disclosure and appendant claims.

In the claims, the word "comprising" does not exclude other elements or steps, and the indefinite article "a" or "an" does not exclude a plurality. A single element or other unit may fulfill the function of several items recited in the claims. The mere fact that certain measures are recited in mutually different claims does not indicate that the combination of these measures cannot be used to advantage.

Any reference signs in the claims should not be construed as limiting the scope.

## Claims

1. Method of producing a Vertical Cavity Surface Emitting Laser, comprising:
providing a layer stack (12a) of semiconductor layers, the semiconductor layers of the layer stack (12a) including a first mirror (24a), a second mirror (26a, 28a, 30a), an active region (32a) between the first and second mirrors, an Al₁₋ₓGaₓAs layer with 0 ≤ x ≤ 0.05, and a contact layer (CL) immediately adjacent to the Al₁₋ₓGaₓAs layer;
etching the layer stack (12a) to obtain a first layer sub-stack (16a) forming a mesa and a second layer sub-stack (18a) adjacent to the mesa in stacking direction of the layer stack (12a), the layers of the second layer sub-stack (18a) extend beyond the layers of the first layer sub-stack (16a) in direction perpendicular to the stacking direction, and using the Al₁₋ₓGaₓAs layer as an etch-stop layer;
removing an outer part (66) of the Al₁₋ₓGaₓAs layer to expose in part the contact layer (CL);
oxidizing the Al₁₋ₓGaₓAs layer to obtain an oxide aperture layer (34a).

2. Method of claim 1, wherein the etching includes a selective etching process which automatically stops at the Al₁₋ₓGaₓAs layer.

3. Method of claim 2, wherein the selective etching process is a selective wet-chemical or a dry chemical etching process.

4. Method of claim 2 or 3, wherein the selective etching process is preceded by an initial etching process, further comprising stopping the initial etching process one or more layers apart from the Al₁₋ₓGaₓAs layer.

5. Method of claim 4, wherein the initial etching process is a dry etching process.

6. Method of any of claims 1 to 5, wherein the contact layer (42) has a doping concentration sufficient for ohmic behaviour of the contact layer (42).

7. Method of claim 6, wherein the doping concentration in the contact layer (42) gradually decreases in thickness direction of the contact layer (42) from a side facing the oxide aperture layer to the opposite side, or the doping concentration gradually decreases from the contact layer (42) to an adjacent layer on a side of the contact layer (42) facing away from the oxide aperture layer (34).

8. Method of any one of claims 1 to 7, wherein the contact layer (42) has a thickness of at least 10 nm.

9. Method of any one of claims 1 to 8, wherein the contact layer (42) is a p-doped contact layer.

10. Method of any one of claims 1 to 9, wherein the layer stack (12a) comprises a photodiode having an intrinsic absorption region (44) integrated into one of the first and second mirrors (24, 26, 28, 30).

11. Method of claim 10, wherein the second mirror has a first portion (28) facing the contact layer (42), which is a p-doped region of the layer stack (12), and a second portion (26) facing away from the contact layer (42), which is an n-doped region of the layer stack (12), wherein the intrinsic absorption region (44) of the photodiode is arranged between the first and second portions (26, 28) of the second mirror.

12. Method of any one of claims 1 to 11, wherein the first mirror (24) is an n-doped region of the layer stack (12).

13. Method of any one of claims 1 to 12, wherein at least one mirror layer pair of the second mirror (30) is arranged between the active region (32) and the oxide aperture layer (34).

## Patentansprüche

1. Verfahren zur Herstellung von einem oberflächenemittierenden Laser mit vertikalem Resonator, umfassend:
Bereitstellen eines Schichtstapels (12a) aus Halbleiterschichten, wobei die Halbleiterschichten des Schichtstapels (12a) einen ersten Spiegel (24a), einen zweiten Spiegel (26a, 28a, 30a), einen aktiven Bereich (32a) zwischen dem ersten und dem zweiten Spiegel, eine Al₁₋ₓGaₓAs-Schicht mit 0 ≤ x ≤ 0,05 und eine Kontaktschicht (CL) unmittelbar benachbart der Al₁₋ₓGaₓAs-Schicht beinhalten;
Ätzen des Schichtstapels (12a), um einen ersten Schichtteilstapel (16a), der eine Mesa bildet, und einen zweiten Schichtteilstapel (18a) zu erhalten, der in Stapelrichtung des Schichtstapels (12a) benachbart zu der Mesa ist, wobei sich die Schichten des zweiten Schichtteilstapels (18a) über die Schichten des ersten Schichtteilstapels (16a) in einer Richtung senkrecht zur Stapelrichtung erstrecken, und Verwenden der Al₁₋ₓGaₓAs-Schicht als Ätzstoppschicht;
Entfernen eines äußeren Teils (66) der Al₁₋ₓGaₓAs-Schicht, um einen Teil der Kontaktschicht (CL) freizulegen;
Oxidieren der Al₁₋ₓGaₓAs-Schicht, um eine Oxid-Aperturschicht (34a) zu erhalten.

2. Verfahren nach Anspruch 1, wobei das Ätzen einen selektiven Ätzprozess beinhaltet, der automatisch an der Al₁₋ₓGaₓAs-Schicht stoppt.

3. Verfahren nach Anspruch 2, wobei der selektive Ätzprozess ein selektiver nasschemischer oder ein trockenchemischer Ätzprozess ist.

4. Verfahren nach Anspruch 2 oder 3, wobei dem selektiven Ätzprozess ein anfänglicher Ätzprozess vorausgeht, der ferner Stoppen des anfänglichen Ätzprozesses in einer oder mehreren Schichten außer der Al₁₋ₓGaₓAs-Schicht umfasst.

5. Verfahren nach Anspruch 4, wobei der anfängliche Ätzprozess ein Trockenätzprozess ist.

6. Verfahren nach einem der Ansprüche 1 bis 5, wobei die Kontaktschicht (42) eine Dotiermittelkonzentration aufweist, die für ein ohmsches Verhalten der Kontaktschicht (42) ausreicht.

7. Verfahren nach Anspruch 6, wobei die Dotiermittelkonzentration in der Kontaktschicht (42) in Richtung der Dicke der Kontaktschicht (42) von einer der Oxid-Aperturschicht zugewandten Seite zur gegenüberliegenden Seite allmählich abnimmt, oder die Dotiermittelkonzentration von der Kontaktschicht (42) zu einer benachbarten Schicht auf einer von der Oxid-Aperturschicht (34) abgewandten Seite der Kontaktschicht (42) allmählich abnimmt.

8. Verfahren nach einem der Ansprüche 1 bis 7, wobei die Kontaktschicht (42) eine Dicke von mindestens 10 nm aufweist.

9. Verfahren nach einem der Ansprüche 1 bis 8, wobei die Kontaktschicht (42) eine p-dotierte Kontaktschicht ist.

10. Verfahren nach einem der Ansprüche 1 bis 9, wobei der Schichtstapel (12a) eine Fotodiode mit einem intrinsischen Absorptionsbereich (44) aufweist, die in einen der ersten und zweiten Spiegel (24, 26, 28, 30) integriert ist.

11. Verfahren nach Anspruch 10, wobei der zweite Spiegel einen ersten Abschnitt (28), der der Kontaktschicht (42) zugewandt ist, welcher ein p-dotierter Bereich des Schichtstapels (12) ist, und einen zweiten Abschnitt (26) aufweist, der von der Kontaktschicht (42) abgewandt ist, welcher ein n-dotierter Bereich des Schichtstapels (12) ist, wobei der intrinsische Absorptionsbereich (44) der Photodiode zwischen dem ersten und zweiten Abschnitt (26, 28) des zweiten Spiegels angeordnet ist.

12. Verfahren nach einem der Ansprüche 1 bis 11, wobei der erste Spiegel (24) ein n-dotierter Bereich des Schichtstapels (12) ist.

13. Verfahren nach einem der Ansprüche 1 bis 12, wobei mindestens ein Spiegelschichtpaar des zweiten Spiegels (30) zwischen dem aktiven Bereich (32) und der Oxid-Aperturschicht (34) angeordnet ist.

## Revendications

1. Procédé de production d'un laser à émission de surface à cavité verticale consistant à :
fournir un empilement de couches (12a) de couches semi-conductrices, les couches semi-conductrices de l'empilement de couches (12a) comportant un premier miroir (24a), un second miroir (26a, 28a, 30a), une zone active (32a) entre les premier et seconds miroirs, une couche d'Al₁₋ₓGaₓAs avec 0 ≤ x ≤ 0,05 et une couche de contact (CL) immédiatement adjacente à la couche d'Al₁₋ₓGaₓAs ;
graver l'empilement de couches (12a) pour obtenir un premier sous-empilement de couches (16a) formant un mésa et un second sous-empilement de couches (18a) adjacent au mésa dans la direction d'empilement de l'empilement de couches (12a), les couches du second sous-empilement de couches (18a) s'étendant au-delà des couches du premier sous-empilement de couches (16a) dans la direction perpendiculaire à la direction d'empilement, et utiliser la couche d'Al₁₋ₓGaₓAs comme couche d'arrêt de gravure ;
retirer une partie extérieure (66) de la couche d'Al₁₋ₓGaₓAs pour rendre apparente une partie de la couche de contact (CL) ;
et oxyder la couche d'Al₁₋ₓGaₓAs pour obtenir une couche d'ouverture d'oxyde (34a).

2. Procédé selon la revendication 1, dans lequel la gravure comporte un processus de gravure sélective qui s'arrête automatiquement à la couche d'Al₁₋ₓGaₓAs.

3. Procédé selon la revendication 2, dans lequel le processus de gravure sélective est un procédé de gravure chimique par voie humide sélective ou un processus de gravure chimique par voie sèche.

4. Procédé selon la revendication 2 ou 3, dans lequel le processus de gravure sélective est précédé d'un processus initial de gravure, comprenant en outre l'arrêt du processus initial de gravure sur une ou plusieurs couches en dehors de la couche d'Al₁₋ₓGaₓAs.

5. Procédé selon la revendication 4, dans lequel le processus initial de gravure est un processus de gravure par voie sèche.

6. Procédé selon l'une quelconque des revendications 1 à 5, dans lequel la couche de contact (42) a une concentration de dopage suffisant pour le comportement ohmique de la couche de contact (42).

7. Procédé selon la revendication 6, dans lequel la concentration de dopage dans la couche de contact (42) diminue progressivement dans la direction de l'épaisseur de la couche de contact (42) d'un côté faisant face à la couche d'ouverture d'oxyde au côté opposé, ou dans lequel la concentration de dopage diminue progressivement de la couche de contact (42) à une couche adjacente d'un côté de la couche de contact (42) tourné à l'opposé de la couche d'ouverture d'oxyde (34).

8. Procédé selon l'une quelconque des revendications 1 à 7, dans lequel la couche de contact (42) présente une épaisseur supérieure ou égale à 10 nm.

9. Procédé selon l'une quelconque des revendications 1 à 8, dans lequel la couche de contact (42) est une couche de contact dopée p.

10. Procédé selon l'une quelconque des revendications 1 à 9, dans lequel l'empilement de couches (12a) comprend une photodiode dont une zone d'absorption intrinsèque (44) est intégrée dans un miroir parmi les premier et second miroirs (24, 26, 28, 30).

11. Procédé selon la revendication 10, dans lequel le second miroir a une première partie (28) faisant face à la couche de contact (42), qui est une zone dopée p de l'empilement de couches (12), et une seconde partie (26) tournée à l'opposé de la couche de contact (42), qui est une zone dopée n de l'empilement de couches (12), la zone d'absorption intrinsèque (44) de la photodiode étant agencée entre les première et seconde parties (26, 28) du second miroir.

12. Procédé selon l'une quelconque des revendications 1 à 11, dans lequel le premier miroir (24) est une zone dopée n de l'empilement de couches (12).

13. Procédé selon l'une quelconque des revendications 1 à 12, dans lequel au moins une paire de couches miroir du second miroir (30) est agencée entre la zone active (32) et la couche d'ouverture d'oxyde (34).
